# EUROPEAN PATENT APPLICATION

(11) **EP 2 361 003 A2**
(43) Date of publication of application: **24.08.2011**
(21) Application number: 11153599.3
(22) Date of filing: 07.02.2011
(51) Int. Cl.: H05K 5/02

(54) **Use of token switch to indicate unauthorized manipulation of a protected device**

(30) Priority: 15.02.2010 US 705701
(71) Applicant: Honeywell International Inc., Morristown, NJ 07962 (US)
(72) Inventor: TOUCHBERRY, Alan B., Morristown, NJ 07962 (US); DALZELL, Jr., William J., Morristown, NJ 07962 (US); KALLAY, Richard, Morristown, NJ 07962 (US); CLARK, Matthew, Morristown, NJ 07962 (US); MILLER, Gregory A., Morristown, NJ 07962 (US); BAKER, Stephen M., Morristown, NJ 07962 (US); ECKLUND, Steven P., Morristown, NJ 07962 (US)
(74) Representative: Buckley, Guy Julian

(57) **Abstract**

An apparatus to indicate unauthorized manipulation of at least one protected device enclosed in a housing is provided. The apparatus includes a structure attached to a first portion of the housing and a token switch attached to a second portion of the housing. The token switch is operably positioned with reference to the structure. The token switch includes a plunger, and a register programmed with a value. The register is communicatively coupled with a processor in a circuit. The circuit is communicatively coupled to drive the device. The structure, the token switch, and the circuit are internal to the housing when the housing is in a closed position. The plunger and the structure are positioned to generate a current when the housing is opened. The programmed value in the register is changed by the generated current and the processor takes an action responsive to the change in the programmed value.

## Description

### BACKGROUND

Some electronic components are sensitive to tampering and will no longer function properly if the housing in which the electronic component is enclosed is opened. If the user of such a component attempts to undertake repairs or to examine the electronic component, the user may unwittingly render the electronic component inaccurate and/or unusable.

### SUMMARY

The present application relates to an apparatus to indicate unauthorized manipulation of at least one protected device enclosed in a housing. The apparatus includes a structure attached to a first portion of the housing and a token switch attached to a second portion of the housing. The token switch is operably positioned with reference to the structure. The token switch includes a plunger, and a register programmed with a value. The register is communicatively coupled with a processor in a circuit. The circuit is communicatively coupled to drive the device. The structure, the token switch, and the circuit are internal to the housing when the housing is in a closed position. The plunger and the structure are positioned to generate a current when the housing is opened. The programmed value in the register is changed by the generated current and the processor takes an action responsive to the change in the programmed value.

### DRAWINGS

Figures 1A and 1B are an embodiment of an apparatus to indicate unauthorized manipulation of a protected device enclosed in a housing in accordance with the present invention;
Figure 2A shows an enlarged view of an embodiment of a magnetic token switch in position with a portion of a structure when the housing is in the open position in accordance with the present invention;
Figure 2B shows an enlarged view of the magnetic token switch of Figure 2A when the housing is in the closed position in accordance with the present invention;
Figures 3A and 3B shows views of an embodiment of a plate having a hole encircled by a magnetic ring in accordance with the present invention;
Figure 4A shows an enlarged view of an embodiment of a piezoelectric token switch in contact with the plate when the housing is in the closed position in accordance with the present invention;
Figure 4B shows the enlarged view of the piezoelectric token switch of Figure 4A when the housing is in the initial stages of being opened;
Figure 4C shows the enlarged view of the piezoelectric token switch of Figures 4A and 4B when the housing is completely open; and
Figure 5 illustrates a flow chart, representative of an embodiment of a method of indicating unauthorized manipulation of a protected device enclosed in a housing in accordance with the present invention.

Like reference numbers and designations in the various drawings indicate like elements.

### DETAILED DESCRIPTION

Electronic and/or optical components that are sensitive to tampering may be rendered inaccurate if the electronic and/or optical component is disturbed and/or misaligned by a non-skilled technician. It is advantageous that the electronic and/or optical component be rendered inoperable or flagged as erroneous if tampered with, in order to prevent use of the inaccurate electronic and/or optical components, since use of an inaccurate electronic and/or optical component can cause degraded performance or malfunction. If the electronic and/or optical component is part of a safety critical device, degraded performance or malfunction can have unfortunate consequences. For example, gyroscopes used in navigation systems are very sensitive to misalignments caused by tampering. Since a misaligned gyroscope can result in degraded performance, which could lead to an accident, it is useful to render a misaligned gyroscope unusable or to flag the misaligned gyroscope as erroneous so that the user of the navigation system recognizes that there is a problem. Embodiments of an apparatus and method to indicate that the electronic and/or optical component was tampered with and is therefore unusable are described herein.

Tampering or unauthorized manipulation of a protected electronic and/or optical component typically occurs when the electronic and/or optical component is powered down. The embodiments of the apparatus and methods described herein can be implemented with or without the electronic and/or optical component and/or related circuitry being powered up.

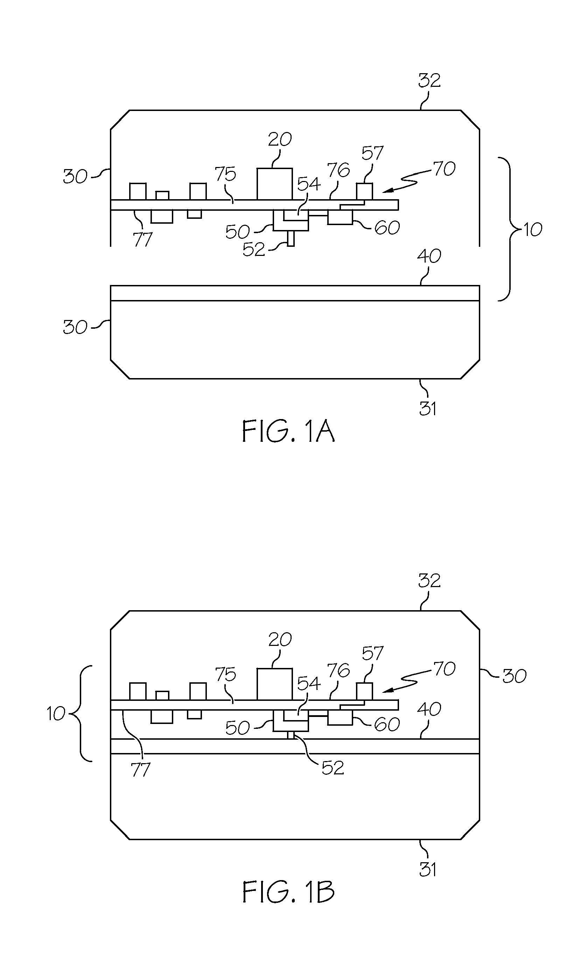

Figures 1A and 1B are an embodiment of an apparatus 10 to indicate unauthorized manipulation of at least one protected device 20 enclosed in a housing 30 in accordance with the present invention. Figure 1A is an embodiment of the apparatus 10 to protect a device 20 when the housing 30 is in the open position. Figure 1B is an embodiment of the apparatus 10 to protect a device 20 when the housing 30 is in the closed position. The device 20 is one or more of an optical device, an electronic device, an opto-electronic device. In one implementation of this embodiment, the device 20 is a gyroscope 20. In another implementation of this embodiment, the device 20 is a ring-laser gyroscope 20. In yet another implementation of this embodiment, the device 20 is an accelerometer 20. In yet another implementation of this embodiment, the device 20 includes at one or more of at least one navigation sensor, at least one inertial sensor, at least one gyroscope, at least one accelerometer, at least one magnetometer, at least one pressure sensor, at least one air data sensor, and other types of safety critical devices.

The apparatus 10 includes a structure 40 attached to a first portion 31 of the housing 30, the token switch 50 attached to a second portion 32 of the housing 30, and a circuit 70 communicatively coupled to drive the device 20. As shown in Figures 1A and 1B, the structure 40 is a plate 40 that extends across an opening in the first portion 31 of the housing 30. In other embodiments the structure 40 is a ledge in the first portion 31 or a protrusion from a floor of the first portion 31 that extends into at least a portion of a center region of the housing. The terms "structure" and "plate" are used interchangeably herein.

The token switch 50 includes a plunger 52 and at least one register 54, which is programmed with an initial value prior to operation of the circuit 70. The value is a randomized constant value that is known to registered users and is unknown to unregistered users. The register 54 is communicatively coupled with a processor 60 in the circuit 70. The processor 60 reads the value in the register 54 when the circuit 70 is powered up. The circuit 70 is communicatively coupled to drive the device 20. In one implementation of this embodiment, the circuit 70 is a surface mounted circuit card on a printed circuit board (PCB) 75. The PCB 75 has a top surface 76 and an opposing bottom surface 77. The token switch 50 is attached to the bottom surface 77 of the PCB 75. The plate 40, the token switch 50, the circuit 70, and the device 20 are internal to the housing 30 when the housing 30 is in a closed position.

The plunger 52 and the plate 40 are positioned to generate a current when the housing 30 is opened. The current changes the programmed value stored in the register 54. In one implementation of this embodiment, the current nulls the programmed value stored in the register 54. The current is generated without a power source so that the detection of manipulation of a protected device 20 occurs when the circuit 70 is powered down. The detection of manipulation of a protected device 20 can also occur when the device is powered up. In this case, the processor 60 detects the change in the state of the register 54 and takes an action.

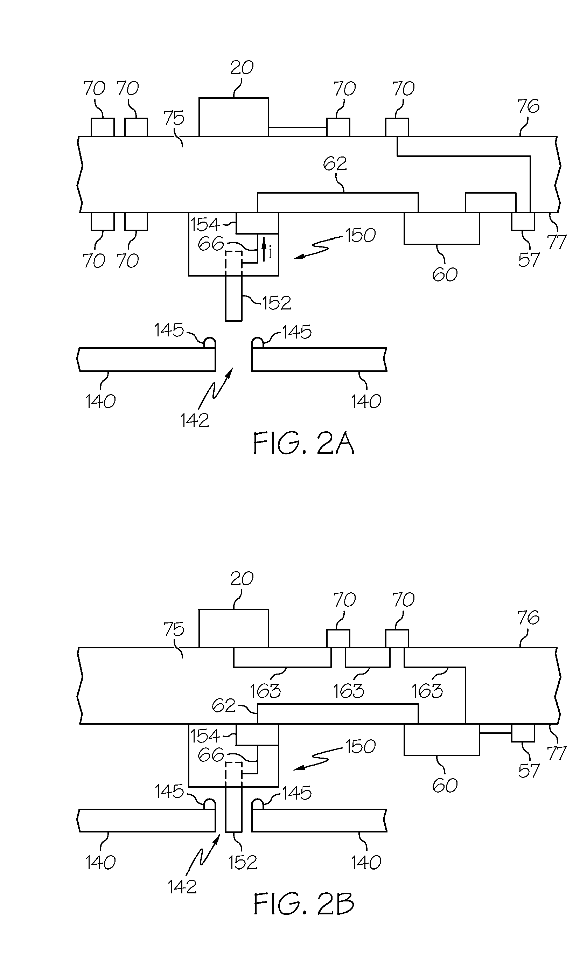

In one implementation of this embodiment, the token switch 50 is a magnetic token switch 150. Figure 2A shows an enlarged view of an embodiment of a magnetic token switch 150 in position with a portion of the plate 141 when the housing 30 is in the open position (Figure 1A) in accordance with the present invention. In this embodiment, the structure attached to a first portion 31 of the housing 30 is a plate 140 with a hole 142 encircled by a magnetic material 145. The magnetic token switch 150 has a magnetic plunger 152 formed from a magnetic material. Figure 2B shows an enlarged view of the magnetic token switch 50 of Figure 2A when the housing 30 is in the closed position (Figure 1B).

The magnetic plunger 152 and the plate 140 are configured so that the magnetic plunger 152 is positioned external to the hole 142 when the housing 30 is open and so that the magnetic plunger 152 is positioned inside of the hole 142 and encircled by the magnetic material 145 when the housing 30 is closed. In this manner, when the housing 30 is opened from the closed position, the movement of the magnetic plunger 152 out of the hole 142, generates current due to the movement of the magnetic plunger 152 from inside of the magnetic ring 145 to outside of the magnetic ring 145. The magnetic ring 145 is a permanent magnet. As shown in Figure 2A, the current i is transmitted from the magnetic plunger 152 to the register 154 via link 66. When the current i is received at the register 154, the value in the register 154 is changed or cleared.

Since a current is also generated when the housing 30 is closed, the value in the register 154 is programmed once the housing 30 is closed and the magnetic plunger 152 is inside the magnetic ring 145. The value in the register 154 is a password or code that is known by the manufacturer who assembles the device 20 in the housing 30 and/or is known by a skilled technician who is authorized to work on the device 20 in the housing 30. The value stored in the register 154 is also stored as a password or code in a memory 57 that is communicatively coupled to the processor 60 when the apparatus 10 is manufactured and/or initialized. In one implementation of this embodiment, the value stored in the register 154 is also stored as a password or code in the processor 60.

Each time that the protected device 20 in the housing 30 is powered up, the processor 60 reads the value of the register 154 via link 62, and checks to make sure that the value in the register 154 matches a password or code stored in the memory 57. The processor 60 permits the circuit 70 to operate once the password is determined to match the value in the register 154. The circuit 70 drives the protected device 20. In embodiments in which the protected device 20 includes more than one device 20, such as at least one navigation sensor, at least one inertial sensor, at least one gyroscope, at least one accelerometer, at least one magnetometer, at least one pressure sensor, and/or at least one air data sensor (or other safety critical devices), the circuit 70 runs the two or more devices. Exemplary links 163 within the printed circuit board 75, communicatively couple the processor 60, circuit 70, and the protected device 20.

If the housing 30 has been opened by an unregistered user who does not reprogram the value in the register 154, the value in the register 154 does not match the password/codeword stored in the memory 57 the next time the circuit 70 is powered up to drive the device 20. In this case, the processor 60 is prompted to take an action. The action taken by the processor 60 indicates to a user that the housing 30 has been opened. In one implementation of this embodiment, the processor 60 can set a flag to indicate that the housing 30 has been opened. In another implementation of this embodiment, the processor 60 renders the circuit 70 inoperable to drive the device 20 if the housing 30 has been opened. In yet another implementation of this embodiment, the processor 60 causes the circuit 70 to operate the device 20 in a degraded manner if the housing 30 has been opened. The degraded manner is obvious to a user of the device 20. In yet another implementation of this embodiment, the processor 60 causes the circuit 70 to display a message to the user indicating an error in the device 20 or a tampering with the housing 30 if the housing 30 has been opened. In some embodiments, more than one of these actions is taken when the housing is opened.

If a registered technician opens the housing 30 to perform maintenance or other procedures, the registered technician reprograms the register 154 with the password that is recognizable by the processor 60 after the maintenance is completed and the housing 30 is closed again. If an unregistered user opens the housing 30, the unregistered user is unable to reprogram the register 154 with the value that is recognizable by the processor 60 as the password, since the unregistered user does not know the password.

The memory 57 comprises any suitable memory now known or later developed such as, for example, random access memory (RAM), read only memory (ROM), and/or registers within the processor 60. In one implementation, the processor 60 comprises a microprocessor or microcontroller. Moreover, although the processor 60 and memory 57 are shown as separate elements in Figure 1, in one implementation, the processor 60 and memory 57 are implemented in a single device (for example, a single integrated-circuit device). In one implementation, the processor 60 comprises processor support chips and/or system support chips such as application-specific integrated circuits (ASICs). The processor 60 executes software (not shown) stored in a storage medium (not shown) to make the processor take the actions described herein. The software executed by the processor 60 is stored in the processor 60 or in the memory 57.

As shown in Figures 2A and 2B, the hole 142 is shown to extend completely through the plate 140. In some embodiments, the hole 142 is a cavity of sufficient depth for the magnetic plunger 152 to extend at least partially into the cavity without touching the plate 140. In such an embodiment, the entrance to the cavity is enclosed by a magnetic material 145 or the inside of the cavity is encircled with the magnetic material 145.

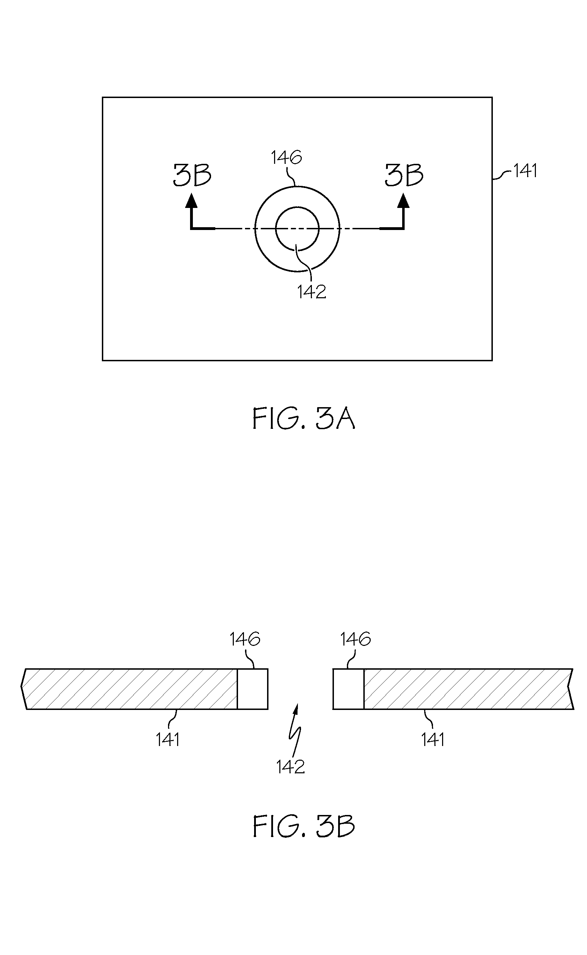

As shown in Figures 2A and 2B, permanent magnet 145 is on the top surface of the plate 140 and circling the hole 142. Figures 3A and 3B shows views of an embodiment of a plate 141 having a hole 142 encircled by a magnetic ring 146 in accordance with the present invention. Figure 3A is a top view of the plate 141. Figure 3B is a cross-sectional side view of the plate 141. The plane upon which the cross-section view of Figure 3B is taken is indicated by section line 3B-3B in Figure 3A. The plate 141 includes a permanent magnet 146 with a hole 142 extending through the permanent magnet 146. Other configurations for encircling a hole in a plate with a permanent magnet are possible.

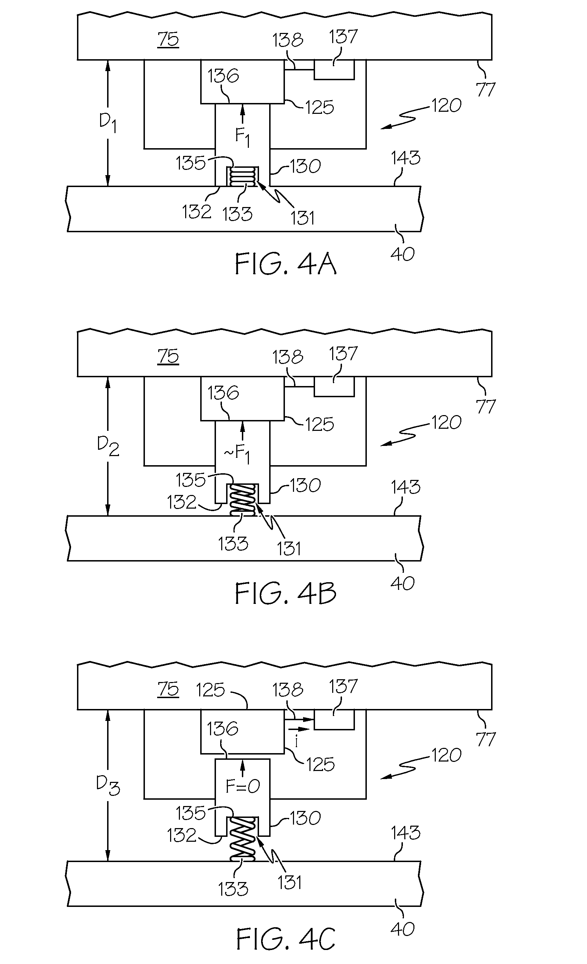

In another embodiment, the token switch 50 in the apparatus 10 is a piezoelectric token switch 120 as shown in Figures 4A-4C. The piezoelectric token switch 120 includes at least one register 137, a piezoelectric element 125, and a plunger 130. The plunger 130 is operably positioned to be in a retracted mode as shown in Figure 4A or an extended mode as shown in Figure 4C. When in the retracted mode, the plunger 130 applies a first pressure to the piezoelectric element 125 as indicated by the arrow F1. When in the extended mode, the plunger 130 applies a second pressure, as indicated by the arrow F, to the piezoelectric element 125. The second pressure is less than the first pressure. When the pressure on the piezoelectric element 125 is changed, a current is generated by the piezoelectric element 125 as shown in Figure 4C. The current generated by the piezoelectric element 125 is transmitted to the register 137 and the value in the register 137 is changed.

In the embodiments of the piezoelectric token switch 120 shown in Figures 4A and 4C, snap mechanism 133 is positioned within the plunger 130. The snap mechanism 133, indicated in this embodiment, as a spring is held within the plunger 130 by an indent 131 in an end surface 132 of the plunger 130. The snap mechanism 133 ensures that the pressure change on the piezoelectric element 125 is abrupt enough to generate the current. In this manner, a slow gradual opening of the housing 30, which would allow incremental changes to the pressure on the piezoelectric element 125, is not possible. The incremental changes in pressure of the piezoelectric element 125 could result in no current being transmitted from the piezoelectric element 125 to the register 137.

Figure 4A shows an enlarged view of an embodiment of a piezoelectric token switch 120 in contact with the plate 40 when the housing 30 is in the closed position in accordance with the present invention. When the housing 30 is in the closed position, there is a distance D1 between the bottom surface 77 of the PCB 75 and the top surface 143 of the plate 40. The snap mechanism 133 is the spring 133 that is compressed between a floor 135 of the indent 131 and the top surface 143 of the plate 40. The plunger 130 applies the first pressure to the piezoelectric element 125 as indicated by the arrow F1. The first pressure P1 equals F1 divided by the unit area of the end face 136 of the plunger 130.

Figure 4B shows the enlarged view of the piezoelectric token switch 120 of Figure 4A when the housing 30 is in the initial stages of being opened. When the housing 30 is initially opened, the distance between the PCB 75 and the top surface 143 of the plate 40 has increased to D2. The snap mechanism 133 is still under compression since the spring 133 is still compressed between the floor 135 of the indent 131 and the top surface 143 of the plate 40. The pressure on the piezoelectric element 125 is approximately F1. The pressure may be slightly less that the first pressure depending on the design of the spring 133 and the plunger 130 since the compression on the spring 133 is reduced. A threshold indicative of an opening of the housing 30 is set by the snap mechanism 133. For the spring-type snap mechanism 133 shown in Figures 4A-4C, the threshold indicative of an opening of the housing 30 is exceeded when the spring 133 no longer forces the plunger 130 against the piezoelectric element 125. Other types of snap mechanisms are possible. All the types of snap mechanisms cause the quick change in pressure on the piezoelectric element 125 even if there is a slow gradual opening of the housing 30.

Figure 4C shows the enlarged view of the piezoelectric token switch 120 of Figures 4A and 4B when the housing 30 is completely open. The distance between the PCB 75 and the top surface 143 of the plate 40 has increased to D3. The spring 133 is no longer compressed between the floor 135 of the indent 131 and the top surface 143 of the plate 40. The change in pressure on the piezoelectric element 125 generates a charge since plunger 130 there is a change in pressure on the piezoelectric element 125. A current is generated by a change in pressure on a piezoelectric element 125. In the embodiment shown in Figure 4C, there is zero pressure (F = 0) on the piezoelectric element 125 since the plunger 130 does not contact the piezoelectric element 125. In other embodiments, the second pressure is non-zero and is less than the first pressure and the change in pressure occurs over a sufficiently short duration and is of sufficient difference to generate a current. The generated current is transmitted to the register 137 via link 138.

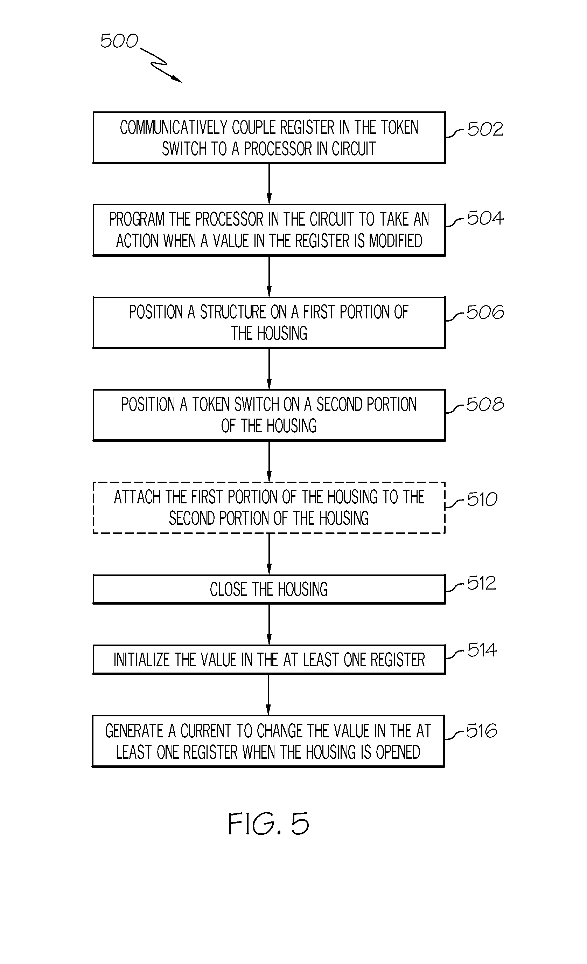

Figure 5 illustrates a flow chart, representative of an embodiment of a method 500 of indicating unauthorized manipulation of a protected device 20 enclosed in housing 30 in accordance with the present invention. Method 500 can be implemented by the apparatus 10 illustrated in Figures 1A and 1B, in which the token switch 50 is the magnetic token switch 150 shown in Figures 2A and 2B. Likewise, method 500 can be implemented by the apparatus 10 illustrated in illustrated in Figures 1A and 1B in which the token switch is the piezoelectric token switch 120 shown in Figures 4A-4C.

At block 502, at least one register 54 in the token switch 50 is communicatively coupled to a processor 60 in circuit 70 on a PCB 75. A protected device 20 is also attached to the PCB 75. The circuit 70 is configured to drive the protected device 20. The circuit 70 can be on the top surface 76 of the PCB 75 or the bottom surface 77 of the PCB 75 as shown in Figure 2A. The token switch 50 is attached to the bottom surface 77 of the PCB 75. At block 504, the processor 60 in the circuit 70 is programmed to take an action when a value in the register 54 is modified. The action can be to shut down the circuit 70 to render it inoperable, to set a flag in the circuit 70, to degrade the performance of the protected device 20, or to send an indication of tampering to a user of the protected device 20 when it is powered up the next time.

At block 506, a structure 40 is positioned on a first portion 31 of the housing 30. In one implementation of this embodiment, the structure 40 positioned in the first portion 31 of the housing 30 is the plate 140 having a hole 142 encircled by a magnetic ring 145. In another implementation of this embodiment, the structure 40 positioned in the first portion 31 of the housing 30 is the plate 40. In yet another implementation of this embodiment, the first portion 31 of the housing is a bottom portion of the housing for a gyroscope 20.

At block 508, a token switch 50 is positioned on a second portion 32 of the housing 30. The relative position of the token switch 50 and the structure 40 is such that the plunger 52 and structure 40 are positioned to generate a current that changes the register 54 in the token switch 50 when the housing 30 is opened, as is understandable to one skilled in the art upon reading this document. In one implementation of this embodiment, the token switch 50 positioned on the second portion 32, is the magnetic token switch 150 and the plate positioned in the first portion 31 of the housing 30 during block 506 was the plate 140 having a hole 142 encircled by a magnetic ring 145. In another implementation of this embodiment, the token switch 50 positioned on the second portion 32, is the piezoelectric token switch 120 and the plate positioned in the first portion 31 of the housing 30 during block 506 was the plate 40 that does not require a hole 142. In yet another implementation of this embodiment, the second portion 32 of the housing 30 is a top portion 32 of the housing for a gyroscope 20.

At block 510, the first portion 31 of the housing 30 is attached to the second portion 32 of the housing 30. This is an optional step. In one implementation of this embodiment, the attachment used to connect the first portion 31 to the second portion 32 is a hinging apparatus.

At block 512, the housing 30 is closed so that the token switch 50 is operable to generate a current to change the value in the register 54 in the token switch 50 when the housing 30 is opened. In order to close the housing 30, the first portion 31 is mated to the second portion 32. If block 510 is not an implemented step in method 500, then the first portion 31 to the second portion 32 are mated together by a clipping mechanism and/or by adhesives. In this manner, the device 20 is enclosed by the first and second portions 31 and 32 of the housing 30. In one implementation of this embodiment, a ring laser gyroscope is enclosed in a housing 30.

In an embodiment in which the token switch 50 is a magnetic token switch 150, closing the housing 30 so that the token switch 50 is operable to generate a current to change a value in the register 54 in the token switch 50 when the housing 30 is opened comprises positioning the magnetic plunger 152 within the hole 142 of the plate 141 when the housing 30 is closed.

In embodiment in which the token switch 50 is a piezoelectric token switch 120, closing the housing 30 so that the token switch 50 is operable to generate a current to change a value in the register 54 in the token switch 50 when the housing 30 is opened comprises positioning the plunger 130 in a retracted mode in order to apply pressure on the piezoelectric element 125 (as shown in Figure 4A) when the housing 30 is closed.

In this manner, the token switch 50 is operable to generate current to modify the value in the register 54 in the token switch 51 when the first and second portions 31 and 32 of the housing 30 are separated.

At block 514, the value is initialized in the at least one register 54. The value is initialized after the housing is closed since the act of closing the housing to align the token switch 50 with respect to the plate 40 creates a current that is sent to the register 54. In one implementation of this embodiment, the value is initialized in the register 54 via a lead line, which extends through a seam in the closed housing 30. In another implementation of this embodiment value is initialized in the register 54 via a wireless signal transmitted to the token switch 50.

At block 516, a current is generated in the token switch 52 when the housing 30 is opened and the current changes the value in the register 54. The next time the protected device 20 in the housing 30 is used, the processor 60 takes an action to indicate to the user that the housing 30 was opened by an unauthorized person. The user is then aware that the protected device 20 may malfunction due to the opening of the housing 30 by the unauthorized person.

Although specific embodiments have been illustrated and described herein, it will be appreciated by those skilled in the art that any arrangement, which is calculated to achieve the same purpose, may be substituted for the specific embodiment shown. This application is intended to cover any adaptations or variations of the present invention. For example, the plate 40 can be a ledge or lip on an inner portion of the first portion 31 of the housing 30. In this case, the plunger 52 of the token switch 50 is positioned with reference to the ledge or lip to generate current when the housing is opened. Therefore, it is manifestly intended that this invention be limited only by the claims and the equivalents thereof.

## Claims

1. An apparatus (10) to indicate unauthorized manipulation of at least one protected device (20) enclosed in a housing (30), the apparatus comprising:
a structure (40) attached to a first portion (31) of the housing;
a token switch (50) attached to a second portion (32) of the housing, the token switch operably positioned with reference to the structure, the token switch including:
a plunger (52), and
a register (54) programmed with a value, the register communicatively coupled with a processor (60) in a circuit (70);
the circuit communicatively coupled to drive the device, wherein the structure, the token switch, and the circuit are internal to the housing when the housing is in a closed position,
wherein the plunger and the structure are positioned to generate a current when the housing is opened, wherein the programmed value in the register is changed by the generated current, and wherein the processor takes an action responsive to the change in the programmed value.

2. The apparatus (10) of claim 1, wherein the action taken by the processor (60) is at least one of rendering the circuit (70) inoperable to drive the device (20), setting a flag indicative of the change in the programmed value, causing the circuit to operate the device in a degraded manner, causing the circuit to display a message to a user indicating an error in the device, and causing the circuit to display a message to the user indicating a tampering with the housing.

3. The apparatus (10) of claim 1, wherein the token switch (50) is a magnetic token switch (150) having a magnetic plunger (152), wherein the structure (140) includes a hole (142) encircled by a magnetic ring (145), wherein the magnetic plunger and structure are configured so that the magnetic plunger is positioned within the hole when the housing is closed and the magnetic plunger is positioned external to the hole when the housing is open, and wherein, when the housing is opened, the movement of the magnetic plunger out of the hole encircled by the magnetic ring generates the current.

4. The apparatus (10) of claim 1, wherein the token switch (50) is a piezoelectric token switch (120) including a piezoelectric element (125), and wherein the plunger (130) is operably positioned to be in a retracted mode when the housing (30) is closed, and wherein the plunger is operably positioned to be in an extended mode when the housing is open, such that, in the retracted mode, the plunger applies a first pressure to the piezoelectric element, and, in the extended mode, the plunger applies a second pressure to the piezoelectric element, the second pressure being less than the first pressure.

5. The apparatus (10) of claim 4, wherein the piezoelectric element (125) generates the current when the pressure of the plunger (130) on the piezoelectric element changes from the first pressure to the second pressure.

6. The apparatus (10) of claim 4, wherein the piezoelectric token switch (120) further comprises a snap mechanism (133) configured to switch the plunger (130) from the retracted mode to the extended mode when a threshold indicative of an opening of the housing (30) is exceeded.

7. The apparatus (10) of claim 4, wherein the second pressure is zero pressure.

8. The apparatus (10) of claim 1, further comprising the device (20) enclosed in the housing (30), wherein the device includes one or more of at least one navigation sensor, at least one inertial sensor, at least one gyroscope, at least one accelerometer, at least one magnetometer, at least one pressure sensor, and at least one air data sensor, and wherein circuit runs the at least one device.

9. The apparatus (10) of claim 1, wherein the register is programmed with the value prior to operation of the circuit (70), wherein the processor (60) reads the register (54) when the circuit is powered up, and if the read value in the register differs from the programmed value, and the processor takes the action.

10. The apparatus of claim 1, wherein the structure is a plate extending across an opening in the first portion of the housing, wherein the circuit is a surface mounted circuit card, and wherein the token switch is attached to the circuit card.
